(19) Europäisches Patentamt
European Patent Office
Office européen des brevets

(11) Publication number: **0 030 107**
**B1**

(12) # EUROPEAN PATENT SPECIFICATION

(45) Date of publication of patent specification: **06.02.85**

(51) Int. Cl.⁴: **G 03 F 7/26,** G 03 F 7/08 // H01L21/312, H01L21/47

(21) Application number: **80304172.2**

(22) Date of filing: **20.11.80**

(54) **Process for forming resist pattern.**

(30) Priority: **30.11.79 JP 154179/79**

(43) Date of publication of application:
**10.06.81 Bulletin 81/23**

(45) Publication of the grant of the patent:
**06.02.85 Bulletin 85/06**

(84) Designated Contracting States:
**DE FR GB NL**

(56) References cited:
**GB-A-1 071 560**
**US-A-3 923 522**
**US-A-3 929 488**

**Solid State Technology, August 1979, pp. 87-94 "An Overview of Electron Beam masking."**

(73) Proprietor: **FUJITSU LIMITED**
**1015, Kamikodanaka Nakahara-ku**
**Kawasaki-shi Kanagawa 211 (JP)**

(72) Inventor: **Toda, Kazuo**
**4-11-9, Shinjyo Nakahara-ku**
**Kawasaki-shi Kanagawa 211 (JP)**

(74) Representative: **Allman, Peter John et al**
**Marks and Clerk Scottish Life House Bridge Street**
**Manchester M3 3DP (GB)**

**EP 0 030 107 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

*FIELD OF THE INVENTION*

This invention relates to a process for forming a resist pattern on a substrate using electron beams. More particularly, this invention relates to a process for forming a resist pattern possessing a high definition on a substrate using electron beams.

*BACKGROUND OF THE INVENTION*

It is well known that a variety of resist materials are utilized to form a desired pattern on a substrate in the production of semiconductor devices. These resist materials are usually classified into two types, namely, positive-type resist materials, which are adapted to form a positive image on a substrate, and negative-type resist materials, which are adapted to form a negative image on a substrate. A portion of the positive resist material which is exposed to rays such as electron beam and X-rays is dissolved in a developer and, as a result of this, a positive image is formed, while an unexposed portion of the negative resist material is dissolved in a developer and, as a result of this, a negative image is formed.

The negative and positive resist materials are used selectively depending upon such factors as the desired image, the particular developer utilized, the particular pattern-forming step used, the particular etching step utilized and the like.

However, in general, the negative resist materials, such as polyvinyl cinnamate photoresists and cyclized rubber photoresists, provide image having a low definition, which are inferior to those formed through the use of the positive resist materials such as phenolformaldehyde novolak resin photoresists. Usually, the negative resist materials can provide images having a maximum definition of only 2 µm. This is because the negative resist material is developed with an organic solvent capable of swelling the resist material, thereby dissolving an unexposed portion thereof. During the development operation, the exposed portion of the resist material which is the pattern to be formed increases in width by approximately 1 µm. This phenomenon causes the resultant pattern to be in contact with the adjacent patterns.

In addition, during the exposure operation, the exposed portion of the negative resist material undergoes a cross-linking reaction. The cross-linked portion becomes completely insoluble in the developer. After the development operation is completed, the portion of the resist material cross-linked due to the reflection or scattering of electrons remains as a bridge, which results in a reduction in the definition of the resultant pattern.

Furthermore, after the negative resist material is exposed to a desired pattern of electron beams in a high vacuum in an exposure apparatus, if it is left to stand in the apparatus within which a high vacuum is retained, an additional cross-linking reaction spontaneously proceeds in the resist material, i.e. a vacuum curing effect is developed therein, whereby an excessive curing of the resist material takes place. Accordingly, it is difficult to control the thickness and width of the resultant pattern.

*SUMMARY OF THE INVENTION*

In view of the above, the present inventors made extensive studies to develop a process for the formation of a negative resist pattern possessing a high definition on a substrate. As a result, the present inventors found that the use of the resist material comprising a phenol-formaldehyde novolak resin and a compound containing at least one azido radical makes it possible to obtain negative images possessing a high definition which are suitable for the formation of fine patterns.

US Patent No. 3923522 discloses the light exposure of a resist material comprised of a phenol-formaldehyde novolak resin and a compound containing at least one azido radical. No suggestion is made however that such a resist material should be exposed to an electron beam. The present inventors have established that the electron-beam exposure of such a resist material produces a negative resist pattern of a resolution much higher than that produced by the light exposure of the resist material.

According to the present invention there is provided a process for the formation of a desired negative resist pattern on a substrate by electron beam exposure with a high definition, comprising the sequential steps of:

coating on the substrate a negative-working resist material comprising a mixture of a phenol-formaldehyde novolak resin and a compound containing at least one azido radical selected from the group consisting of 4,4'-diazidochalcone, 2,6-bis-(4'-azidobenzal)-cyclohexanone, 2,6-bis-(4'-azidobenzal)-4-methylcyclohexanone, 2,6-bis-(4'-azidobenzal)-acetone, azidopyrene, and p-azidobenzalaceto-phenone;

prebaking said resist material at a temperature from 80°C to 90°C for 15 to 45 minutes;

exposing the coated resist material to a desired electron beam pattern to obtain a corresponding pattern of cross-linking of said at least one azido radical, the amount of said cross-linking depending on the amount of the exposure to the electron beam;

postbaking said resist material at a temperature in the range from 60 to 100°C for 10 to 60 minutes; and

developing the desired negative resist pattern by removing the resist material that was not exposed to said electron beam.

*BRIEF DESCRIPTION OF THE DRAWINGS*

Fig. 1 is a graph illustrating the relationship between the sensitivity of the resist material according to the present invention and the definition of the resultant resist pattern when the resist material is left to stand in a high vacuum after exposure, and;

Fig. 2 is a graph illustrating the relationship between the sensitivity of the resist material according to the present invention and the definition of the resultant resist pattern when the development time is varied.

*DETAILED DESCRIPTION OF THE INVENTION*

In order to ensure the formation of a pattern of a high reproducibility, the resist material is baked at a temperature of from 60 to 100°C for 10 to 60 minutes after the exposure of the resist material to electron beams.

The negative-working resist material usable for the present invention comprises a phenol-formaldehyde novolak resin, expressed by the formula:

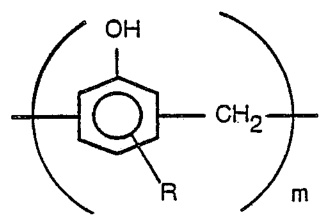

wherein R represents a hydrogen atom or an alkyl radical having 1 to 5 carbon atoms, which is known as a material for conventional positive-working resist materials, and a compound containing at least one azido radical.

In the production of the negative-working resist material of the present invention, the phenol-formaldehyde novolak resin and the azido radical-containing compound are mixed together by using a conventional mixing procedure.

With regard to the resist materials according to this invention, the ratio of the compound containing at least one azido radical to the phenol-formaldehyde novolak resin is not specified or limited. However, in general, the azido radical-containing compound is preferably incorporated into the novolak resin in an amount of from 50 to 1 parts by weight per 50 to 99 parts by weight of the novolak resin. If the amount of the azido radical-containing compound is less than 1 part by weight, the resultant resist material will form no negative resist pattern. If the azido radical-containing compound is added in an amount exceeding 50 parts by weight, it will be difficult to form a satisfactory coating film on the substrate by using the resist material.

The compound containing at least one azido radical may be selected from the group consisting of 4,4'-diazidochalcone, 2,6-bis(4'-azidobenzal)-cyclohexanone, 2,6-bis(4'-azidobenzal)-4-methylcyclohexanone, 2,6-bis(4'-azidobenzal)-acetone, p-azidobenzalacetophenone and azidopyrene.

The formation of a negative resist pattern on a substrate, such as Si, $SiO_2$, polycrystaline silicon and the like, using the negative-working resist material according to the present invention is carried out as follows.

The substrate is preliminarily washed in a conventional manner to improve the adhesive property of the resist material thereon. Then, the surface of the pre-washed substrate is uniformly coated with the resist material according to this invention, namely, the negative-working resist material comprising a phenol-formaldehyde novolak resin having incorporated therein a compound containing at least one azido radical, in accordance with a conventional coating method, such as spray coating, spinner coating, dip coating, roll coating and the like. In general, spinner coating is considered to be preferable from the point of view of the uniformity of the resist coating formed thereby on the substrate and the safety of the coating operation. The coated resist material is then prebaked to completely remove the solvent remaining in the resist coating. Usually, the prebaking procedure is carried out at a temperature of from 80 to 90°C for 15 to 45 minutes. The prebaking devices which can be employed are well known in the art and include a source for generating infrared rays, a convection heater, a convection oven, a circulating hot air oven and the like.

The resist coating is exposed to electron beams through a mask having a desired pattern. Then, the exposed resist coating is baked at a temperature of from 60 to 100°C from 10 to 60 minutes thereby to promote the cross-linking reaction of an exposed portion of the resist coating.

Then, the heated resist coating may be developed with an alkaline developer or an organic solvent by using a conventional developing procedure, to dissolve an unexposed portion of the resist coating in the developer and, simultaneously, to retain an exposed portion of the resist coating on the substrate. Thus, the negative image or resist pattern is formed on the substrate. The alkaline developer may be selected from any conventional alkaline developers for the conventional positive resist material, such as an aqueous solution of an alkali material selected from the group consisting of potassium hydroxide, sodium hydroxide and organic alkali materials. The thus obtained negative image or resist pattern possesses a high definition.

Although the mechanism by which the phenol-formaldehyde novolak resin having incorporated

therein the azido radical-containing compound becomes negative-working is not fully understood, it is considered that when the novolak resin is exposed to electron beams, the exposed portion of the novolak resin reacts with the azido radical to form a product insoluble in an aqueous solution of an alkali or the exposed portion thereof undergoes a cross-linking reaction so that it is converted to a gel-like product insoluble in the alkaline solution.

The negative image or resist pattern formed according to the process of this invention can be used to produce semiconductor devices and the like after the resist coating containing such image or pattern is subjected to the conventional processing steps, such as etching, removal of the resist coating and washing.

The present invention will be further illustrated by the examples set forth below, which are provided for the purpose of illustration and should not be interpreted as in any way limiting the scope of the present invention.

Example 1

100 parts by weight of a phenol-formaldehyde novolak resin having a number average molecular weight of approximately 4000, which was prepared from the condensation reaction of phenol with formaldehyde according to a conventional procedure, were mixed with 10 parts by weight of 2,6-bis(4'-azidobenzale)-4-methylcyclohexanone. The mixture was dissolved in methyl cellosolve acetate so as to form a solution containing 10% by weight of the mixture. The solution was applied onto a silicon wafer substrate by using a spinner coating method to form a resist coating having a thickness of 500 nm (5000Å.)

After coating, the resist coating was prebaked at a temperature of 80°C for 20 minutes and, then, subjected to an exposure procedure by means of electron beams accelerated at an acceleration voltage of 20KeV, to form an imagewise pattern on the coating. Thereafter, the exposed resist coating was baked at a temperature of 80°C for 20 minutes to facilitate the cross-linking reaction of its exposed portion.

The heated resist was then developed with a developer consisting of 1 part by volume of MF312, and 3 parts by volume of water at room temperature. The MF312 is an aqueous organic alkali solution for a positive type resist material which is manufactured by SHIPLEY. A non-exposed portion of the resist coating was dissolved in the developer. Then, the resist coating retained on the substrate was rinsed with water for 30 seconds. A negative image or resist pattern of a 1 µm Line & Space was formed on the substrate. The resultant negative image or resist pattern possessed a sensitivity of $3 \times 10^{-5}$ C/cm$^2$ and a definition of 1 µm.

Then, a vacuum curing effect on the negative resist material of this invention was examined in the following manner.

Two series of silicon wafers were coated with the same coating liquid as that described above, to form a resist coating having a thickness of 550 nm (5500 Å) on each of the wafers. The same prebaking and exposure procedures as those described above were applied to these resist coatings, except that the electron beam radiation dose (coulomb/cm$^2$) was varied. After the exposure procedure, one series of resist coatings was immediately removed from the exposure apparatus, while the other series of resist coatings was left to stand within the exposure apparatus for 60 minutes whle keeping the inside thereof at a high vacuum and, then, removed from the apparatus. Then, the same baking procedure as that described above was applied to these two series of resist coatings. Thereafter, the two series of baked resists were developed with the same developer as that described above at a temperature of 20°C for 20 seconds. A non-exposed portion of each of the resist coatings was dissolved in the developer. Thereafter, the resultant image or resist patterns were rinsed with water for 30 seconds. The thickness of these resist patterns was evaluated. The results are shown in Fig. 1.

Fig. 1 is a graph illustrating a relationship between the sensitivity of the resist material and the thickness of the resultant resist pattern, and wherein the ordinate represents a normalized thickness of the resist pattern and the abscissa represents a raiation dose. In Fig. 1, the triangle sign, △, represents a case where the resist coating was not left to stand in a high vacuum after exposure, while the circle sign, ○, represents a case where the resist coating was left to stand in a high vacuum for 60 minutes after exposure. As can be seen from Fig. 1, no difference in normalized thickness was observed between these two series of resist patterns. Accordingly, these results clearly indicate that no vacuum curing effect, i.e. spontaneous cross-linking reaction, occurs in the resist material of the present invention even if it is left to stand in a high vacuum after exposure.

On the contrary, in the case of the conventional negative resist material, the spontaneous cross-linking reaction proceeds if it is left to stand in a high vacuum after exposure, which makes it difficult to control the thickness and width of the resultant pattern.

In addition, in the case of the conventional negative resist material, the cross-linked portion of the resist material is completely insoluble. Therefore, the portion of the resist material cross-linked due to the reflection or scattering of electrons remains as a bridge after development, which results in a reduction in the definition of the resultant pattern.

In contrast, in the case of the resist material of the present invention, the cross-linked portion thereof is slightly soluble in the alkaline developer. Particularly, the bridge portion is more soluble than the other cross-linked portion. This is because the radiation dose to which the bridge portion is exposed is lower than that for the other cross-linked portion. Accordingly, by controlling the developing operation, it is possible to remove the bridge portion by dissolving it only, so that the definition of the resultant resist pattern can be

increased. This is demonstrated in Fig. 2 which is a graph illustrating the relationship between the sensitivity of the resist material and the definition of the resultant resist pattern, and wherein the ordinate represents a normalized thickness of the resist pattern and the abscissa represents a radiation dose. In this case, the resist pattern was formed according to the same procedure as those described in the above-mentioned example, except that the developing operation was carried out for 30 seconds or 60 seconds. In Fig. 2, the circle sign, ○, represents a case where the developing time was 30 seconds, while the triangle sign, △, represents a case where the developing time was 60 seconds. Fig. 2 clearly indicates that the bridge portion can be completely removed by using a longer time of development.

Example 2

100 parts by weight of the same novolak resin as used in Example 1 were mixed with 15 parts by weight of p-azidobenzalacetophenone of the formula:

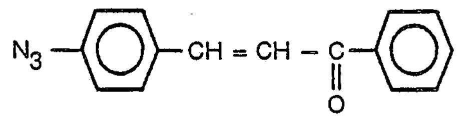

The mixture was dissolved in methyl cellosolve acetate so as to form a solution containing 10% by weight of the mixture. The solution was applied onto a silicon wafer substrate by using a spinner coating method to form a resist coating having a thickness of 8000 Å.

After coating, the resist coating was prebaked at a temperature of 80°C for 20 minutes and, then, subjected to an exposure procedure by means of electron beams accelerated at an acceleration voltage of 20KeV, to form an imagewise pattern on the coating. Thereafter, the exposed resist coating was baked at a temperature of 80°C for 20 minutes to facilitate the cross-linking reaction of its exposed portion. The heated resist was then developed with a developer consisting of 1 part by volume of MF312 and 5 parts by volume of water at room temperature. A non-exposed portion of the resist coating was dissolved in the developer. Then, the resist coating retained on the substrate was rinsed with water for 30 seconds. A negative image or resist pattern of a 1 µm Line & Space was formed on the substrate. The resultant negative image or resist pattern possessed a sensitivity of $2 \times 10^{-5}$ C/cm$^2$ and a definition of 1 µm.

In addition, the conventional electron beam resist material exhibits a poor resistance to dry etching. In contrast, the resist material of the present invention exhibits a resistance to dry etching several times better than that of polyglycidylmethacrylate and polydiallylorthophthalate materials.

**Claim**

1. A process for the formation of a desired negative resist pattern on a substrate by electron beam exposure with a high definition, comprising the sequential steps of:

coating on the substrate a negative-working resist material comprising a mixture of a phenol-formaldehyde novolak resin and a compound containing at least one azido radical selected from the group consisting of 4,4'-diazidochalcone, 2,6-bis-(4'-azidobenzal)-cyclohexanone, 2,6-bis-(4'-azidobenzal)-4-methylcyclohexanone, 2,6-bis-(4'-azidobenzal)-acetone, azidopyrene, and p-azidobenzalaceto-phenone;

prebaking said resist material at a temperature from 80°C to 90°C for 15 to 45 minutes;

exposing the coated resist material to a desired electron beam pattern to obtain a corresponding pattern of cross-linking of said at least one azido radical, the amount of said cross-linking depending on the amount of the exposure to the electron beam;

postbaking said resist material at a temperature in the range from 60 to 100°C for 10 to 60 minutes; and

developing the desired negative resist pattern by removing the resist material that was not exposed to said electron beam.

**Ansprüche**

1. Verfahren zur Bildung eines gewünschten negativen Resistmusters mit scharfer Begrenzung auf einem Substrat durch Elektronenbestrahlung, gekennzeichnet, durch die aufeinanderfolgenden Schritte:

Überziehen des Substrats mit einem negativ arbeitenden Material, welches eine Mischung aus einem Phenol-formaldehyd-Novolak-Harz und einer Verbindung umfaßt, die wenigstens ein Azidoradikal von der Gruppe bestehend aus 4,4'-Diazidochalcon, 2,6-Bis-(4'-azidobenzal)-4-methylcyclohexanon, 2,6-Bis-(4'-azidobenzal)-aceton, Azidopyren und p-Azidobenzalacetophenon besteht;

Vorbacken des genannten Resistmaterials bei einer Temperatur von 80°C bis 90°C, 15 bis 45 Minuten lang;

Bestrahlen des überzogenen Resistmaterials mit einem gewünschten Elektronenstrahlmuster, um ein entsprechendes Muster von Vernetzungen des genannten wenigstens einen Azidoradikals zu erhalten, wobei der Grad der Vernetzungen von der Menge der Elektronenbestrahlung abhängt;

Nachbacken des genannten Resistmaterials bei einer Temperatur in Bereich von 60°C bis 100°C, 10 bis 60 Minuten lang; und

Entwickeln des gewünschten negativen Resistmusters durch entfernen des Resistmaterials, welches nicht dem Elektronenstrahl ausgesetzt war.

**Revendication**

1. Procédé de formation d'une configuration en vernis sensible négative voulue sur un substrat par exposition à un faisceau électronique avec une définition élevée, comprenant les opérations successives suivantes:

faire déposer sur le substrat un vernis sensible à action négative comprenant un mélange d'une résine novolaque de phénol-formaldéhyde et un composé contenant au moins un radical azido choisi dans le groupe formé de la 4,4'-diazidochalcone, la 2,6-bis-(4'-azidobenzal)cyclohexanone, la 2,6-bis-(4'-azidobenzal)-4-méthylcyclohexanone, la 2,6-bis-(4'-azidobenzal)acétone, l'azidopyrène, et la p-azidobenzalacétophénone;

précuire ledit vernis sensible à une température de 80°C à 90°C pendant une durée de 15 à 45 minutes;

exposer le vernis sensible déposé à une certaine configuration voulue du faisceau électronique afin d'obtenir une configuration correspondante de réticulation dudit radical azido, le degré de ladite réticulation étant fonction de la quantité de l'exposition au faisceau électronique;

postcuire ledit vernis sensible à une température comprise entre 60 et 100°C pendant une durée de 10 a' 60 minutes; et

développer la configuration en vernis ensible négative voulue en retirant le vernis sensible qui n'a pas été exposé audit faisceau électronique.

Fig. 1

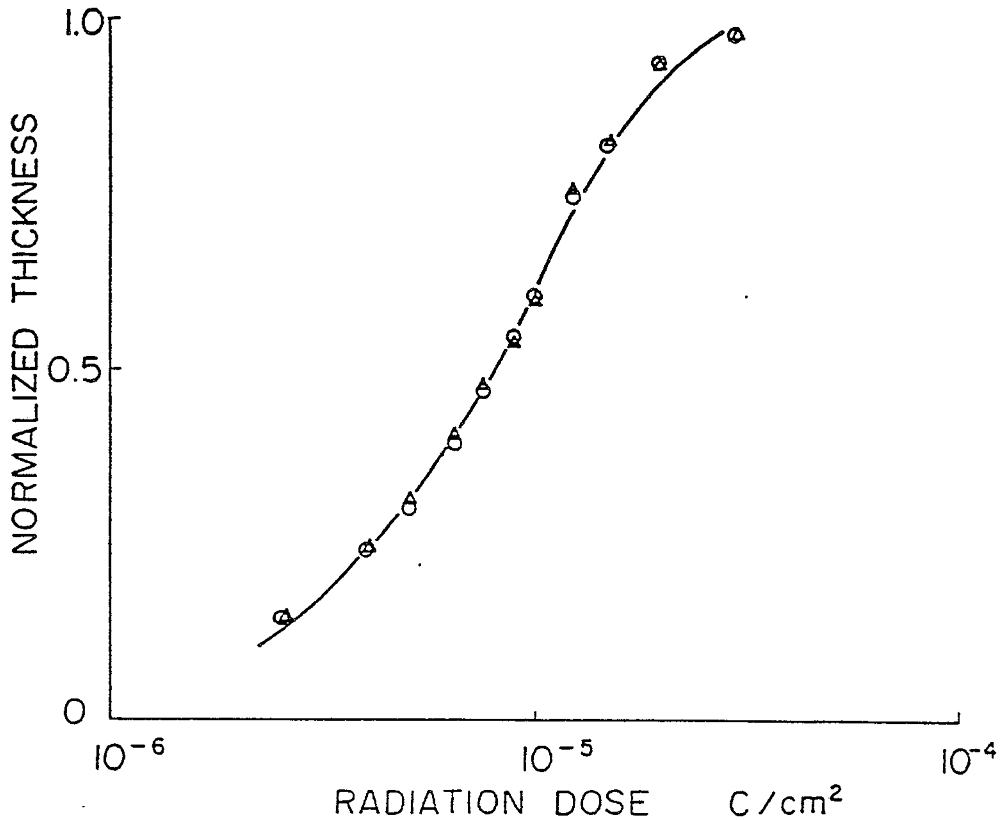
1.0
0.5
0
NORMALIZED THICKNESS
10⁻⁶
10⁻⁵
10⁻⁴
RADIATION DOSE C/cm²

Fig. 2

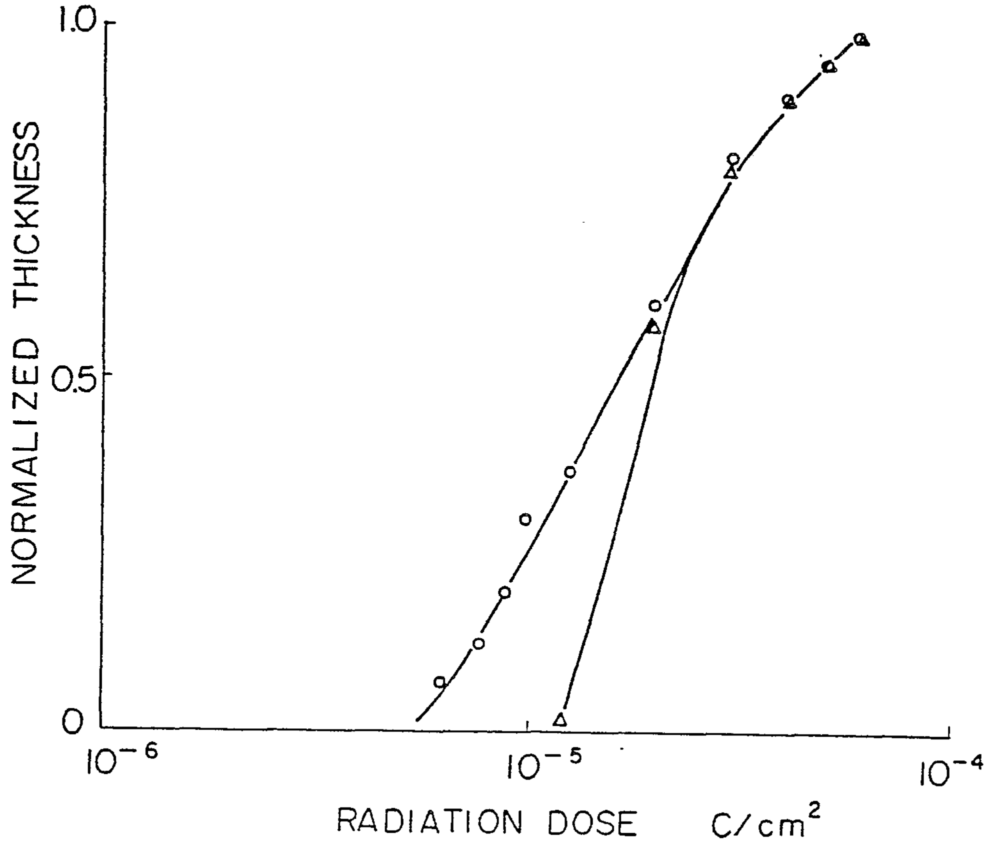
1.0
0.5
0
NORMALIZED THICKNESS
$10^{-6}$
$10^{-5}$
$10^{-4}$
RADIATION DOSE C/cm$^2$